# FASCICULE DE BREVET EUROPEEN

(11) **EP 1 133 059 B1**
(45) Date de publication et mention de la délivrance du brevet: **16.11.2005**
(21) Numéro de dépôt: 01200807.4
(22) Date de dépôt: 05.03.2001
(51) Int. Cl.: H03L 7/197, G06F 7/68

(54) **Covertisseur de fréquence permettant de programmer un rapport de division non-entier au moyen d'un unique mot de consigne**
Frequenzumwandler, welcher Programmierung eines nicht ganzzahligen Teilerverhältnisses ermöglicht durch ein einzelnes Steuerwort
Frequency converter allowing the programming of a non-integer divider ratio by using a unique control word

(30) Priorité: 10.03.2000 FR 0003135
(43) Date de publication de la demande: 12.09.2001
(73) Titulaire: Koninklijke Philips Electronics N.V., 5621 BA Eindhoven (NL)
(72) Inventeur: Canard, David, 75008 Paris (FR); Fillatre, Vincent, 75008 Paris (FR)
(74) Mandataire: Chaffraix, Jean

(56) Documents cités:
- EP-A- 0 551 915
- EP-A- 0 821 488
- US-A- 5 714 896
- PARHAMI: "Computer Arithmetic" août 1999 (1999-08) , OXFORD UNIVERSITY PRESS , OXFORD XP002150554 * alinéa [13.2] - alinéa [13.3] *
- PATENT ABSTRACTS OF JAPAN vol. 010, no. 119 (P-453), 6 mai 1986 (1986-05-06) & JP 60 246437 A (MATSUSHITA DENKI SANGYO KK), 6 décembre 1985 (1985-12-06)

## Description

La présente invention concerne un convertisseur de fréquence incluant un diviseur de fréquence destiné à recevoir un signal d'entrée ayant une fréquence dite d'entrée et à délivrer un signal de sortie ayant une fréquence dite de sortie.

De tels convertisseurs de fréquence sont couramment mis en oeuvre dans des boucles à verrouillage de phase destinées à ajuster et à réguler une fréquence dite d'oscillation d'un signal de sortie d'un oscillateur. Une telle boucle à verrouillage de phase est décrite dans la demande de brevet européen No. EP 0 821 488 A1. Dans la plupart des boucles à verrouillage de phase connues, le convertisseur de fréquence reçoit le signal de sortie de l'oscillateur et délivre à un comparateur de phase/fréquence un signal de sortie ayant une fréquence N fois inférieure à la fréquence d'oscillation, où N est une valeur entière égale à celle du mot de consigne. Le comparateur phase/fréquence compare cette fréquence avec une fréquence, dite de comparaison, d'un signal de référence qui provient, par exemple, d'un oscillateur à quartz. Lorsque la fréquence de sortie du convertisseur de fréquence est inférieure à la fréquence de comparaison, le comparateur phase/fréquence commande une augmentation de la fréquence d'oscillation, jusqu'à ce que la fréquence d'oscillation soit égale à N fois la fréquence de comparaison. La valeur de la fréquence de comparaison étant fixée, le choix de la valeur N du mot de consigne détermine la valeur de la fréquence d'oscillation. L'écart minimum entre deux valeurs de la fréquence d'oscillation est donc égal à la valeur de la fréquence de comparaison. Il a été constaté que les performances en bruit d'une boucle à verrouillage de phase sont d'autant meilleures que la fréquence de comparaison est élevée. Néanmoins, choisir une fréquence de comparaison élevée revient à augmenter la valeur de l'écart minimum entre deux valeurs de la fréquence d'oscillation, cet écart étant, lui, déterminé par les conditions dans lesquelles la boucle à verrouillage de phase est employée. Ainsi, dans des applications où le signal de sortie de l'oscillateur est utilisé pour la réception de signaux télévision numériques hertziens, cet écart minimum est prédéterminé et fixé à 166,67kHz.
Pour maintenir un écart minimum constant tout en augmentant la valeur de la fréquence de comparaison, il est alors nécessaire d'utiliser un convertisseur de fréquence dont le rapport de division a une valeur non-entière. De tels convertisseurs de fréquence sont connus sous l'appellation «fractionnel-N». Leur rapport de division est déterminé par au moins deux paramètres.
La demande de brevet publiée sous le numéro US-A-5 714 896 décrit un tel convertisseur de fréquence. Dans ce convertisseur de fréquence, il y a trois paramètres respectivement appelés M, A et N, qui définissent le rapport de division.
Un utilisateur qui souhaiterait remplacer un convertisseur de fréquence ayant un rapport de division entier par un convertisseur de type fractionnel-N en vue d'améliorer les performances en bruit d'une boucle à verrouillage de phase en utilisant une fréquence de comparaison plus élevée se verra donc en principe obligé de fournir audit convertisseur de fréquence non plus un, mais deux mots de consigne, ce qui le conduira à apporter des modifications significatives et coûteuses de la boucle à verrouillage de phase qu'il avait conçue sur le modèle connu.

La présente invention a pour but de remédier à cet inconvénient en proposant un convertisseur de fréquence destiné à remplacer les convertisseurs de fréquence présents au sein de boucles à verrouillage de phase connues, que l'utilisateur pourra programmer au moyen d'un seul mot de consigne, bien que la boucle à verrouillage de phase ainsi obtenue puisse utiliser une fréquence de comparaison ayant une valeur plus élevée que dans le cas de la boucle à verrouillage de phase connue, permettant ainsi d'obtenir de meilleures performances en bruit sans pour autant modifier l'écart minimum entre deux fréquences d'oscillation.

En effet, selon un aspect l'invention, un convertisseur de fréquence comprend des caractéristiques telles que définies dans la revendication 1.

Grâce à l'invention, les deux paramètres nécessaires à la définition d'un rapport de division non-entier du diviseur de fréquence sont extraits, au sein même du convertisseur de fréquence, et d'une manière parfaitement transparente pour l'utilisateur, sur la base de la valeur N du mot de consigne que l'utilisateur élaborerait pour programmer une boucle à verrouillage de phase connue mettant en oeuvre un convertisseur de fréquence ayant un rapport de division entier.

Pour un grand nombre de diviseurs de type fractionnel-N connus, le rapport de division R peut s'exprimer sous la forme R=M+k/q, où M et k sont les premier et deuxième paramètres, q étant un troisième paramètre entier dont la valeur est prédéterminée par la valeur de l'écart minimum entre deux fréquences d'oscillation, qui doit être maintenu constant. Ainsi, q=FCOMP/FSTEP, où FCOMP est la fréquence de comparaison choisie et FSTEP l'écart minimum. Dans un tel cas de figure, les moyens d'interface inclus dans le convertisseur de fréquence selon l'invention comprendront avantageusement :
. des moyens pour calculer la partie entière du rapport N/q, qui constitue le premier paramètre M, et
. des moyens pour calculer la valeur de la différence N-M.q entre la valeur du mot de consigne et celle du produit des valeurs des premier et troisième paramètres, différence qui constitue le deuxième paramètre k.

Dans un tel mode de mise en oeuvre de l'invention, le premier paramètre est constitué par le quotient de la division de la valeur N du mot de consigne par la valeur du troisième paramètre q, tandis que le deuxième paramètre k est constitué par le reste d'une telle division.

Dans un mode de réalisation particulièrement avantageux de l'invention, si le troisième paramètre est codé sur P bits, les moyens d'interface contiennent :
. un registre à décalage destiné à recevoir le mot de consigne, codé sur L bits, dont les P bits de poids le plus significatif peuvent faire l'objet d'un chargement parallèle,
. un additionneur P bits destiné à recevoir sur une entrée les P bits de poids le plus significatifs du registre à décalage, et sur une autre entrée la valeur complémentée à deux du troisième paramètre, et .
. un séquenceur destiné à cadencer L-P pas de calcul, chaque pas de calcul comprenant les opérations suivantes :
. addition des valeurs présentes sur les entrées de l'additionneur,
. chargement des P bits de poids les moins significatifs du résultat de l'addition dans les P bits de poids les plus significatifs du registre à décalage, si ledit résultat est positif,
. chargement, dans une bascule mémoire accolée au bit de poids le moins significatif du registre à décalage, d'un bit de retenue produit par l'additionneur, et
. décalage dans le sens des bits les plus significatifs du contenu du registre à décalage, la valeur du bit le moins significatif dudit registre devenant celle du bit de retenue.

Ainsi qu'exposé plus haut, un convertisseur de fréquence conforme à l'invention sera avantageusement mis en oeuvre dans une boucle à verrouillage de phase destinée à réguler la fréquence d'un oscillateur, puisqu'elle permet d'améliorer les performances en bruit d'une telle boucle d'une manière transparente pour un utilisateur accoutumé aux boudes à verrouillage de phase connues. L'invention concerne donc également une boucle à verrouillage de phase comprenant :
. un oscillateur destiné à produire un signal de sortie ayant une fréquence d'oscillation dont la valeur dépend de celle d'un signal de réglage,
. un détecteur de phase/fréquence destiné à comparer la fréquence d'oscillation avec une fréquence, dite de comparaison, d'un signal de référence, et à délivrer à l'oscillateur le signal de réglage dont la valeur dépend du résultat de la comparaison, et
. un diviseur de fréquence tel que décrit plus haut, inséré entre l'oscillateur et le détecteur de phase/fréquence.

Dans un mode de mise en oeuvre de telles boucles à verrouillage de phase, invention concerne enfin un appareil destiné à la réception de signaux radioélectriques, par exemple un téléviseur ou un radiotéléphone, incluant :
. un étage d'entrée destiné à recevoir un signal radioélectrique et à convertir ledit signal en un signal de sortie électronique ayant une fréquence dite fréquence radio,
. un oscillateur destiné à délivrer un signal de sortie ayant une fréquence dite d'oscillation, et
. un mélangeur destiné à recevoir les signaux de sortie de l'étage d'entrée et de l'oscillateur, et à délivrer un signal ayant une fréquence égale à la différence entre la fréquence radio et la fréquence d'oscillation,
appareil caractérisé en ce qu'il indut en outre une boucle à verrouillage de phase telle que décrite ci-dessus, destinée à ajuster la valeur de la fréquence d'oscillation.

L'invention sera mieux comprise à l'aide de la description suivante, faite à titre d'exemple non-limitatif et en regard des dessins annexés, dans lesquels:
- la figure 1 est un schéma fonctionnel partiel décrivant un appareil récepteur de signaux radioélectriques mettant en oeuvre l'invention,
- la figure 2 est un schéma fonctionnel décrivant schématiquement un convertisseur de fréquence selon l'invention, et
- la figure 3 est un schéma fonctionnel décrivant des moyens d'interface inclus dans un convertisseur de fréquence conforme à un mode de réalisation préféré de l'invention.

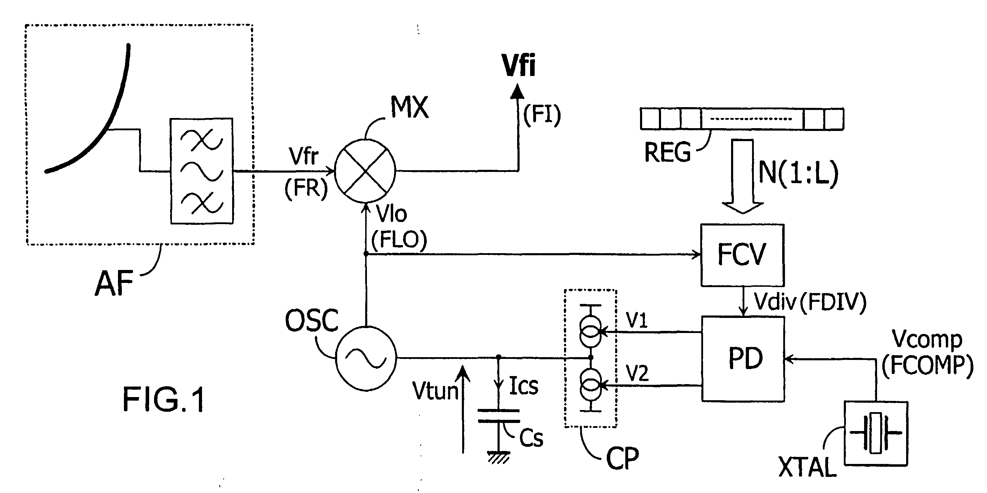

La figure 1 représente schématiquement un appareil récepteur de signaux radioélectriques, par exemple un récepteur de signaux de télévision, comportant un étage d'entrée AF, par exemple un système d'antenne et de filtrage, permettant la réception d'un signal dont la fréquence est sélectionnée au sein d'une gamme de fréquences donnée, et sa transformation en un signal électronique Vfr dit signal radio, ayant une fréquence FR appelée fréquence radio, appareil dans lequel un décalage en fréquence, à partir de la fréquence FR sélectionnée vers une fréquence intermédiaire FI prédéterminée, est réalisé au moyen d'un mélangeur MX destiné à recevoir le signal radio Vfr, d'une part, et un signal de sortie Vlo d'un oscillateur local OSC, d'autre part.
La fréquence intermédiaire FI est fixée et est égale à la différence entre la fréquence radio FR et la fréquence d'oscillation FLO du signal de sortie Vlo du premier oscillateur local OSC. Le choix de ladite fréquence d'oscillation FLO détermine donc la valeur de la fréquence radio FR sélectionnée.
Dans cet appareil, la fréquence d'oscillation FLO du signal de sortie Vlo du premier oscillateur local OSC est régulée au moyen d'un boucle de verrouillage de phase, qui comporte :
. l'oscillateur local OSC destiné à délivrer le signal de sortie Vlo dont la fréquence FLO est déterminée par la valeur d'une tension de réglage Vtun,
. un convertisseur de fréquence FCV, destiné à recevoir le signal de sortie Vlo de l'oscillateur local OSC, et à délivrer un signal de sortie Vdiv ayant une fréquence FDIV, un mot de consigne codé sur L bits N(1:L) programmé par l'utilisateur de l'appareil définissant un rapport de division R entre la fréquence d'oscillation FLO et la fréquence FDIV du signal de sortie du convertisseur de fréquence FCV,
. un détecteur de phase/fréquence PD, destiné à comparer la fréquence FDIV du signal de sortie Vdiv du convertisseur de fréquence FCV avec une fréquence de comparaison FCOMP d'un signal de référence Vcomp, provenant dans cet exemple d'un oscillateur à quartz XTAL, et à délivrer des signaux de commande V1 et V2 représentatifs du résultat de ladite comparaison, et
. une pompe de charge CP dont la conduction est destinée à être contrôlée par des signaux de commande V1 et V2, une sortie de la pompe de charge CP étant reliée à une capacité Cs destinée à générer à ses bornes la tension de réglage Vtun.
Si la fréquence d'oscillation FLO du premier oscillateur local OSC est inférieure à R fois la fréquence FCOMP du signal de référence Vcomp, le détecteur de phase PD place à un état actif un premier signal de commande V1, qui ordonne à la pompe de charge CP de délivrer un courant Ics positif. Ce courant, transmis à la capacité Cs, provoque un accroissement de la valeur de la tension de réglage Vtun prélevée aux bornes de la capacité Cs, et donc un accroissement de la fréquence d'oscillation FLO.
Lorsque la fréquence d'oscillation FLO devient supérieure à celle du signal de référence Vcomp, le détecteur de phase PD place à l'état actif un deuxième signal de commande V2, complémentaire du premier signal de commande V1, ce qui provoque une inversion du sens du courant Ics, qui devient négatif. Ce courant négatif, transmis à la capacité Cs, provoque une diminution de la valeur de la tension de réglage Vtun prélevée aux bornes de la capacité Cs, et donc une diminution de la fréquence d'oscillation FLO. La boucle à verrouillage de phase tendra vers un régime d'équilibre, dans lequel FLO=R.FDIV=R.FCOMP.

Dans nombre de boucles à verrouillage de phase connues, le convertisseur de fréquence n'est autre qu'un diviseur de fréquence ayant un rapport de division entier, dont la valeur est celle du mot de consigne N(1:L). Dans ce type de systèmes, l'écart minimum FSTEP séparant deux fréquences d'oscillation est (N+1).FCOMP-N.FCOMP, et est donc égal à la fréquence de comparaison FCOMP elle-même. Or, cet écart minimum FSTEP est fixé par l'application à laquelle est destiné l'appareil récepteur. Si, par exemple, cet appareil est destiné à la réception de signaux de télévision numériques hertziens, l'écart minimum FSTEP est égal à 166,67 kHz selon la norme OFDM.
Il n'est pas possible d'augmenter la fréquence de comparaison FCOMP, dans le but d'améliorer les performances en bruit de la boucle à verrouillage de phase, en utilisant un diviseur de fréquence à rapport de division entier, car cela conduirait à augmenter la valeur de l'écart minimum FSTEP.
Pour maintenir un écart minimum FSTEP constant tout en augmentant la valeur de la fréquence de comparaison FCOMP, il est alors nécessaire d'utiliser au sein du convertisseur de fréquence un diviseur de fréquence «fractionnel-N», dont le rapport de division a une valeur non-entière, et est déterminé par au moins deux paramètres.
Un utilisateur qui souhaiterait remplacer un diviseur de fréquence ayant un rapport de division entier par un diviseur de type fractionnel-N en vue d'améliorer les performances en bruit d'une boucle à verrouillage de phase en utilisant une fréquence de comparaison plus élevée se verra donc en principe obligé de fournir audit diviseur de fréquence non plus un, mais deux mots de consigne, ce qui le conduira à apporter des modifications significatives et coûteuses de la boucle à verrouillage de phase qu'il avait conçue sur le modèle connu.
Le convertisseur de fréquence FCV conforme à l'invention est programmable au moyen du seul mot de consigne N(1:L) et opère une division non-entière de la fréquence d'oscillation FLO, permettant ainsi d'utiliser une fréquence de comparaison FCOMP plus élevée que l'écart minimum imposé FSTEP entre deux fréquences d'oscillation, en vue d'améliorer les performances en bruit de la boucle à verrouillage de phase.

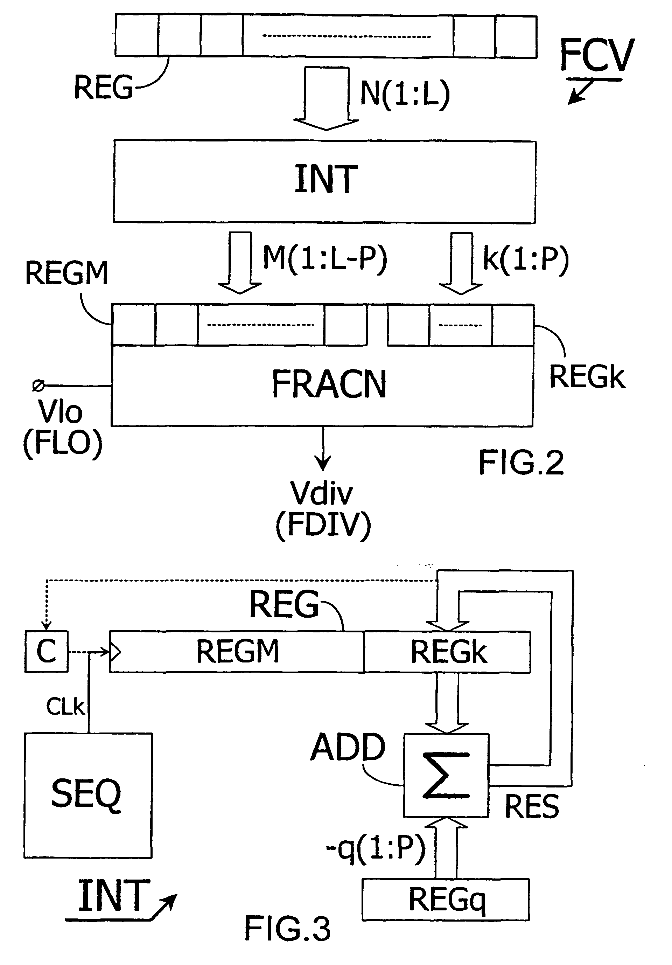

La figure 2 représente schématiquement un convertisseur de fréquence FCV conforme à invention, qui indut :
. un diviseur de fréquence FRACN destiné à recevoir le signal de sortie Vlo de l'oscillateur local et à délivrer un signal de sortie Vdiv ayant une fréquence FDIV dite de sortie, et
. un registre REG relié à un port d'entrée destiné à recevoir le mot de consigne N(1:L).
Le convertisseur de fréquence FCV inclut en outre des moyens d'interface INT, disposés entre le port d'entrée et le diviseur de fréquence FRACN, et destinés à opérer une conversion d'une valeur du mot de consigne en un premier et un deuxième paramètres M(1:L-P) et k(1:P), codés respectivement sur L-P et P bits, définissant une valeur non-entière du rapport de division du diviseur de fréquence FRACN.
Le diviseur de fréquence est ici du type «fractionnel-N», et réalise un rapport de division R entre la fréquence FLO de son signal d'entrée Vlo et la fréquence FDIV de son signal de sortie Vdiv qui s'exprime sous la forme R=FLO/FDIV=M+k/q, où M et k sont les valeurs des premier et deuxième paramètres M(1:L-P) et k(1:P), q étant celle d'un troisième paramètre entier dont la valeur est prédéterminée par la valeur de l'écart minimum entre deux fréquences d'oscillation, qui doit être maintenu constant. Ainsi, q=FCOMP/FSTEP, où FCOMP est la fréquence de comparaison choisie et FSTEP l'écart minimum. Dans l'exemple des signaux de télévision numériques hertziens mentionnés plus haut, FSTEP=166,67kHz, ce qui impliquera que q=24 si l'on choisit FCOMP=4MHz. Les moyens d'interface INT indus dans le convertisseur de fréquence FCV comprennent :
. des moyens pour calculer la partie entière du rapport N/q, qui constitue le premier paramètre M, et
. des moyens pour calculer la valeur de la différence N-M.q entre la valeur du mot de consigne et celle du produit des valeurs des premier et troisième paramètres, différence qui constitue le deuxième paramètre k.

Dans ce mode de mise en oeuvre de l'invention, le premier paramètre M est constitué par le quotient de la division de la valeur N du mot de consigne par la valeur du troisième paramètre q, tandis que le deuxième paramètre k est constitué par le reste d'une telle division. Les modes d'implémentation de ces opérations sont multiples et à la portée de l'homme du métier.

La figure 3 illustre un mode de réalisation particulièrement avantageux des moyens d'interface INT décrits ci-dessus. Dans ce mode de réalisation, les moyens d'interface INT contiennent un registre à décalage REG destiné à recevoir le mot de consigne N(1:L), qui sera avantageusement constitué par le registre qui est relié au port d'entrée, par souci d'économie. Les P bits de poids le plus significatif de ce registre peuvent faire l'objet d'un chargement parallèle. Les moyens d'interface INT contiennent en outre un additionneur P bits ADD, destiné à recevoir sur une entrée les P bits de poids le plus significatif du registre à décalage, et sur une autre entrée la valeur complémentée à deux du troisième paramètre -q(1:P). Les moyens d'interface INT contiennent enfin un séquenceur SEQ destiné à cadencer L-P pas de calcul. Le fonctionnement de ces moyens d'interface est le suivant : dans une phase initiale, l'utilisateur charge dans le registre N le mot de consigne N(1:L). L'opposé de la valeur du troisième paramètre -q(1:P) est automatiquement chargé dans un registre REGq, puisque, comme on l'a vu précédemment, la valeur du troisième paramètre q est connue car imposée par l'application à laquelle est destiné l'appareil qui utilise le convertisseur de fréquence. Le séquenceur SEQ commande alors le début d'un cyde de calcul. Au cours d'un premier pas de calcul, les P bits les plus significatifs du contenu du registre REG sont comparés à la valeur du troisième paramètre q(1:P) par le biais de l'additionneur ADD qui soustrait aux dits P bits les plus significatifs la valeur du troisième paramètre. Si le résultat de la soustraction est positif, un bit de retenue prenant l'état 1 est mémorisé dans une bascule de retenue C. Simultanément, le résultat de la soustraction est chargé dans les P bits les plus significatifs du registre REG. Si le résultat de la soustraction est négatif, un bit de retenue prenant l'état 0 est mémorisé dans la bascule de retenue C, les P bits les plus significatifs du registre REG demeurant inchangés. Au pas de calcul suivant, le séquenceur ordonne au moyen d'un signal d'horloge Clk un décalage de l'ensemble du contenu du registre REG dans le sens des bits les plus significatifs, le bit de retenue devenant ainsi le bit de poids le moins significatif du contenu dudit registre. L'ordre de magnitude du contenu des P bits bits les plus significatifs du registre REG est alors incrémenté de 1. Une nouvelle soustraction est opérée par l'additionneur ADD, dont le résultat, s'il est positif, est à nouveau chargé dans les P bits les plus significatifs du registre REG. Au pas de calcul suivant, le séquenceur SEQ commande un nouveau décalage du contenu du registre REG, puis une nouvelle soustraction, puis un nouveau rechargement si le résultat de la soustraction est positif, et ainsi de suite jusqu'à l'issue du Lème pas de calcul qui constitue la fin du cyde de calcul. En effet, à l'issue du Lème pas de calcul, les L-P bits les moins significatifs du registre REG contiennent le quotient de la division de la valeur du mot de consigne N(1:L) par la valeur du troisième paramètre q(1:P), et donc la valeur du premier paramètre M(1:L-P). Cette portion du registre REG constitue donc le registre REGM décrit plus haut. Les P bits les plus significatifs du registre REG contiennent, eux, le reste de la division de la valeur du mot de consigne N(1:L) par la valeur du troisième paramètre q(1:P), et donc la valeur du deuxième paramètre k(1:P). Cette portion du registre REG constitue donc le registre REGk décrit plus haut.

## Revendications

1. Convertisseur de fréquence incluant :
. un diviseur de fréquence destiné à recevoir un signal d'entrée ayant une fréquence dite d'entrée et à délivrer un signal de sortie ayant une fréquence dite de sortie, le diviseur de fréquence étant agencé pour recevoir un premier et un deuxième paramètre définissant un rapport de division non-entier entre la fréquence d'entrée et la fréquence de sortie, **caractérisé en ce que** le convertisseur de fréquence comprend :
. un port d'entrée destiné à recevoir un mot de consigne déterminant le rapport de division au moyen d'une valeur entière, et
. des moyens d'interface, disposés entre le port d'entrée et le diviseur de fréquence, et destinés à opérer une conversion de la valeur entière du mot de consigne en le premier et le deuxième paramètre pour le diviseur de fréquence .

2. Convertisseur de fréquence selon la revendication 1, **caractérisé en ce que**, le rapport de division R du diviseur de fréquence étant exprimé sous la forme R=M+k/q, où M et k sont respectivement le premier et le deuxième paramètre, q étant un troisième paramètre entier dont la valeur est imposée par un écart minimal prédéterminé qui doit séparer deux valeurs de la fréquence du signal de sortie du diviseur de fréquence, les moyens d'interface incluent :
. des moyens pour calculer la partie entière du rapport N/q entre la valeur entière du mot de consigne N et celle du troisième paramètre q, partie entière qui constitue le premier paramètre, et
. des moyens pour calculer la valeur de la différence entre la valeur entière du mot de consigne et celle du produit des valeurs respectives du premier et du troisième paramètre, différence qui constitue le deuxième paramètre.

3. Convertisseur de fréquence selon la revendication 2, **caractérisé en ce que**, le troisième paramètre étant codé sur P bits, les moyens d'interface contiennent :
. un registre à décalage destiné à recevoir le mot de consigne, codé sur L bits, registre dont les P bits de poids le plus significatif peuvent faire l'objet d'un chargement parallèle,
. un additionneur P bits destiné à recevoir sur une entrée les P bits de poids le plus significatifs du registre à décalage, et sur une autre entrée la valeur complémentée à deux du troisième paramètre, et
. un séquenceur destiné à cadencer L-P pas de calcul,
chaque pas de calcul comprenant les opérations suivantes :
. addition des valeurs présentes sur les entrées de l'additionneur,
. chargement des P bits de poids les moins significatifs du résultat de l'addition dans les P bits de poids les plus significatifs du registre à décalage, si ledit résultat est positif,
. chargement, dans une bascule mémoire accolée au bit de poids le moins significatif du registre à décalage, d'un bit de retenue produit par l'additionneur, et
. décalage dans le sens des bits les plus significatifs du contenu du registre à décalage, la valeur du bit le moins significatif dudit registre devenant celle du bit de retenue.

4. Boucle à verrouillage de phase comprenant :
. un oscillateur destiné à produire un signal de sortie ayant une fréquence d'oscillation dont la valeur dépend de celle d'un signal de réglage,
. un détecteur de phase/fréquence destiné à comparer la fréquence d'oscillation avec une fréquence, dite de comparaison, d'un signal de référence, et à délivrer à l'oscillateur le signal de réglage dont la valeur dépend du résultat de la comparaison, et
. un convertisseur de fréquence conforme à la revendication 1, inséré entre l'oscillateur et le détecteur de phase/fréquence.

5. Appareil destiné à la réception de signaux radioélectriques, induant :
. un étage d'entrée destiné à recevoir un signal radioélectrique et à convertir ledit signal en un signal de sortie électronique ayant une fréquence dite fréquence radio,
. un oscillateur destiné à délivrer un signal de sortie ayant une fréquence dite d'oscillation, et
. un mélangeur destiné à recevoir les signaux de sortie de l'étage d'entrée et de l'oscillateur, et à délivrer un signal ayant une fréquence égale à la différence entre la fréquence radio et la fréquence d'oscillation,
appareil **caractérisé en ce qu'**il inclut en outre une boucle à verrouillage de phase conforme à la revendication 4, destinée à ajuster la valeur de la fréquence d'oscillation.

## Patentansprüche

1. Frequenzumwandler mit:
. einem Frequenzteiler für den Erhalt eines Eingangssignals mit einer so genannten Eingangsfrequenz und für die Ausgabe eines Ausgangssignals mit einer so genannten Ausgangsfrequenz, wobei der Frequenzteiler für den Erhalt eines ersten und eines zweiten Parameters zur Definition eines nicht-ganzzahligen Teilerverhältnisses zwischen der Eingangsfrequenz und der Ausgangsfrequenz angeordnet ist, **dadurch gekennzeichnet, dass** der Frequenzumwandler umfasst:
. einen Eingangsport für den Erhalt eines Vorgabeworts zur Bestimmung des Teilerverhältnisses anhand eines ganzzahligen Werts, und
. Schnittstellenmittel, angeordnet zwischen dem Eingangsport und dem Frequenzteiler und dafür bestimmt, eine Konvertierung des ganzzahligen Werts des Vorgabeworts im ersten und zweiten Parameter des Frequenzteilers vorzunehmen.

2. Frequenzumwandler nach Anspruch 1, **dadurch gekennzeichnet, dass** das Teilerverhältnis R des Frequenzteilers in der Form R=M+k/q ausgedrückt wird, wobei M und k respektive der erste und der zweite Parameter sind und q ein dritter ganzzahliger Parameter ist, dessen Wert von einer vorbestimmten Mindestabweichung vorgegeben wird, die zwei Werte der Frequenz des Ausgangssignals des Frequenzteilers trennen muss, und die Schnittstellenmittel enthalten:
. Mittel für die Berechnung des Gesamtteils des Verhältnisses N/q zwischen dem ganzzahligen Wert des Vorgabeworts N und demjenigen des dritten Parameters q, wobei der Gesamtteil den ersten Parameter bildet, und
. Mittel für die Berechnung des Werts der Differenz zwischen dem ganzzahligen Wert des Vorgabeworts und demjenigen des Produkts der jeweiligen Werte des ersten und des dritten Parameters, wobei die Differenz den zweiten Parameter bildet.

3. Frequenzumwandler nach Anspruch 2, **dadurch gekennzeichnet, dass** der dritte Parameter über P Bits kodiert wird und die Schnittstellenmittel enthalten:
. ein Schieberegister für den Erhalt des Vorgabeworts, kodiert über L Bits, ein Register, bei dem die P Bits mit dem am meisten signifikanten Stellenwert Gegenstand eines parallelen Ladens sein können,
. einen Addierer P Bits für den Erhalt an einem Eingang der P Bits mit dem am meisten signifikanten Stellenwert des Schieberegisters, und an einem anderen Eingang des mit zwei ergänzten Werts des dritten Parameters, und
. einen Sequenzer, bestimmt zum Takten von L-P Rechenschritten,
wobei jeder Rechenschritt die folgenden Operationen enthält:
. Addition der an den Eingängen des Addierers vorhandenen Werte,
. Ladung der P Bits mit dem am wenigsten signifikanten Stellenwert des Ergebnisses der Addition über die P Bits mit dem am meisten signifikanten Stellenwert des Schieberegisters, wenn das besagte Ergebnis positiv ist,
. Ladung in einen dem Bit mit dem am wenigsten signifikanten Stellenwert des Schieberegisters beigefügten Flipflopspeicher eines vom Addierer erzeugten Haltebits, und
. Verschiebung im Sinne der Bits mit dem am meisten signifikanten Inhalt des Schieberegisters des Werts des am wenigsten signifikanten Bits des besagten Registers, welches dasjenige des Haltebits wird.

4. Phasenverriegelungsschleife mit:
. einem Oszillator für die Erzeugung eines Ausgangssignals mit einer Oszillationsfrequenz, deren Wert von demjenigen eines Regelsignals abhängt,
. einem Phasen/Frequenz-Detektor für den Vergleich der Oszillationsfrequenz mit einer so genannten Vergleichsfrequenz eines Vergleichssignals und die Ausgabe des Regelsignals an den Oszillator, dessen Wert vom Ergebnis des Vergleichs abhängt, und
. einem Anspruch 1 entsprechenden Frequenzumwandler, eingefügt zwischen dem Oszillator und dem Phasen/Frequenz-Detektor.

5. Gerät für den Empfang von Funksignalen mit:
. einer Eingangsstufe für den Erhalt eines Funksignals und die Umwandlung des besagten Signals in ein elektronisches Ausgangssignal mit einer mit Funkfrequenz bezeichneten Frequenz,
. einem Oszillator für die Ausgabe eines Ausgangssignals mit einer als Oszillation bezeichneten Frequenz, und
. einem Mischer für den Erhalt der Ausgangsignale von der Eingangsstufe und vom Oszillator und für die Ausgabe eines Signals mit einer Frequenz gleich der Differenz zwischen der Funkfrequenz und der Oszillationsfrequenz,
ein **dadurch gekennzeichnet**es Gerät, dass es außerdem eine Phasenverriegelungsschleife gemäß Anspruch 4 enthält, die für die Anpassung des Werts der Oszillationsfrequenz bestimmt ist.

## Claims

1. A frequency converter comprising:
. a frequency divider intended to receive an input signal having a so-called input frequency, and to supply an output signal having a so-called output frequency, said frequency divider being designed for receiving a first and a second parameter defining a non-integral division ratio between the input frequency and the output frequency, **characterized in that** the frequency converter additionally comprises:
. an input port intended to receive a command word determining the division ratio by means of an integral value,
. interface means arranged between the input port and the frequency divider, which interface means are intended to carry out a conversion of the integral value of the command word to the first and the second parameter for the frequency divider.

2. A frequency converter as claimed in claim 1, **characterized in that**, as the division ratio R of the frequency divider is expressed as: R = M+k/q, where M and k are, respectively, the first and the second parameter, and q is a third integral parameter whose value is imposed by a predetermined minimum interval that is to separate two frequency values of the output signal of the frequency divider, the interface means comprises:
. means for calculating the whole part of the ratio N/q between the integral value of the command word N and that of the third parameter q, which whole part constitutes the first parameter, and
. means for calculating the value of the difference between the integral value of the command word and that of the product of the values of the first and the third parameter,
which difference constitutes the second parameter.

3. A frequency converter as claimed in claim 2, **characterized in that**, as the third parameter is coded on P bits, the interface means comprise:
. a shift register intended to receive the command word, coded on L bits, of which the P bits having the most significant weight may be subjected to parallel loading,
. a P bit adder intended to receive at an input the P bits having the most significant weight of the shift register, and to receive, at another input, the two's complement of the third parameter, and
. a sequencer destined to clock L-P calculating steps, each calculating step
including the following operations:
. the addition of values present at the inputs of the adder,
. loading the P bits having the least significant weight of the result of the addition within the P bits having the most significant weight of the shift register, if the result is positive,
. loading, in a storage flipflop next to the bit having the least significant weight of the shift register, of a carry bit produced by the adder, and
. shifting the sense of the most significant bits of the contents of the shift register, whereby the value of the least significant bit of this register becomes the value of the carry bit.

4. A phase-locked loop comprising:
. an oscillator intended to produce an output signal having an oscillation frequency whose value depends on the value of the control signal,
. a phase/frequency detector intended to compare the oscillation frequency with a so-called comparison frequency of a reference signal, and to supply the control signal to the oscillator, the value of said signal depending on the result of the comparison, and
. a frequency converter as claimed in claim 1, which is arranged between the oscillator and the phase/frequency detector.

5. A device intended to receive radioelectric signals, comprising:
. an input stage intended to receive a radioelectric signal and to convert said signal to an electronic output signal having a so-called radio frequency,
. an oscillator intended to supply an output signal having a so-called oscillation frequency, and
. a mixer intended to receive the output signals from the input stage and the oscillator, and to supply a signal whose frequency is equal to the difference between the radio frequency and the oscillation frequency,
which device is **characterized in that** it comprises, in addition, a phase-locked loop as claimed in claim 4, which is intended to adjust the value of the oscillation frequency.
